# EUROPEAN PATENT APPLICATION

(11) **EP 4 577 023 A1**
(43) Date of publication of application: **25.06.2025**
(21) Application number: 23855061.0
(22) Date of filing: 21.07.2023
(51) Int. Cl.: H10K 71/00, H10K 71/16, C23C 14/04

(54) **DEPOSITION MASK FOR OLED PIXEL DEPOSITION**

(30) Priority: 17.08.2022 KR 20220102759
(71) Applicant: LG INNOTEK CO. LTD, Gangseo-gu Seoul 07796 (KR)
(72) Inventor: LEE, Seung Heon, Seoul 07796 (KR); UM, Tae In, Seoul 07796 (KR)
(74) Representative: M. Zardi & Co S.A.
(86) International application number: PCT/KR2023/010569
(87) International publication number: WO 2024/039090

(57) **Abstract**

A deposition mask according to an embodiment includes a metal plate including a deposition region and a non-deposition region, wherein the deposition region includes at least one effective region and at least one ineffective region, wherein the effective region includes a plurality of through holes, wherein the through holes include a small area hole formed on a first surface of the metal plate; a large area hole formed on a second surface of the metal plate; and a communication portion communicating the small area hole and the large area hole, and wherein the ineffective region includes a plurality of grooves.

## Description

### [Technical Field]

The embodiment relates to a deposition mask for OLED pixel deposition.

### [Background Art]

A display device is applied to various devices. For example, the display device is applied to a small device such as a smartphone or a tablet PC. Alternatively, the display device is applied to a large device such as a TV, a monitor, or a public display (PD). Recently, the demand for ultra-high definition (UHD) with a resolution of 500 PPI (Pixel Per Inch) or higher is increasing. Accordingly, display devices with high resolution are being applied to small devices and large devices.

The display device is classified into a LCD (Liquid Crystal Display) and an OLED (Organic Light Emitting Diode) depending on a driving method.

The LCD is a display device driven using liquid crystal. In addition, OLED is a display device driven using organic matter.

The OLED can achieve an infinite contrast ratio, has a response speed that is 1000 times faster than LCD, and has an excellent viewing angle. Accordingly, the OLED is attracting attention as a display device that can replace the LCD.

The OLED includes a light-emitting layer. The light-emitting layer includes an organic material. The organic material is deposited on a substrate by a deposition mask. The deposition mask may include an open mask (OM) or a fine metal mask (FMM). A deposition pattern corresponding to a pattern formed in the deposition mask is formed on the substrate. Accordingly, the deposition pattern can serve as a pixel.

The open mask is a thin plate that forms a deposition pattern only at a specific location when manufacturing an OLED. The open mask is used in a deposition process for forming a light-emitting layer thereon after a backplane is completed during the display manufacturing process. In other words, the open mask is a mask that does not have a covering region within a range in which the display operates in order to deposit an entire surface of the display. Therefore, the open mask is used when depositing a light-emitting layer with a light-emitting material of one color.

On the other hand, the fine metal mask is used to change a color of a sub-pixel of the light-emitting layer. Therefore, the fine metal mask includes an ultra-fine hole. A process using the fine metal mask must perform several stages of deposition. Therefore, the process requires precise alignment. Accordingly, the process using the fine metal mask is more difficult than the process using the open mask.

When the light-emitting layer of the OLED is deposited by the open mask, only one color light-emitting layer is formed. Therefore, a separate color filter (C/F) is required to implement various colors. On the other hand, when the fine metal mask is used, an RGB light-emitting layer can be formed. Therefore, a separate color filter is not required. In other words, a technology using the fine metal mask is more difficult. However, a method using the fine metal mask is more light-efficient as the method using the fine metal mask does not require a filter to block light, unlike the method using an open mask.

The fine metal mask is generally manufactured by an Invar alloy metal plate containing iron (Fe) and nickel (Ni). Through holes are formed on one surface and other surface of the metal plate and penetrates the one surface and the other surface. The through holes are formed at positions corresponding to pixel patterns. Accordingly, red, green, and blue organic materials can pass through the through holes of the metal plate and be deposited on the substrate. By this, pixel patterns can be formed on the substrate.

Meanwhile, the fine metal mask includes a small area hole formed on one surface of the metal plate and a large area hole formed on the other surface of the metal plate. The small area hole and the large area hole are connected by a connecting portion, thereby forming the through hole.

The fine metal mask is formed in a stick shape. A plurality of fine metal masks are fixed to a deposition substrate through a frame.

At this time, the fine metal mask can be stretched in a longitudinal direction. Accordingly, a stress difference due to a tensile force can occur in a width direction of the mask. The warpage of the fine metal mask can occur due to the stress difference. Therefore, deposition efficiency of a TKIDRL fine metal mask can be reduced.

Therefore, a deposition mask having a new structure capable of solving the above-mentioned problem and a manufacturing method thereof are required.

### [Disclosure]

### [Technical Problem]

The embodiment provides a deposition mask for OLED pixel deposition with improved deposition efficiency.

### [Technical Solution]

A deposition mask according to an embodiment includes a metal plate including a deposition region and a non-deposition region, wherein the deposition region includes at least one effective region and at least one ineffective region, wherein the effective region includes a plurality of through holes, wherein the through holes include a small area hole formed on a first surface of the metal plate; a large area hole formed on a second surface of the metal plate; and a communication portion communicating the small area hole and the large area hole, and wherein the ineffective region includes a plurality of grooves.

### [Advantageous Effects]

The deposition mask according to the embodiment includes an effective region and an ineffective region. A pattern is formed in the effective region and the ineffective region. The pattern is formed as a hole or a groove.

Therefore, a stress difference that occurs when the deposition mask is tensioned is reduced. When the deposition mask is tensioned, stress due to tension is generated. The stress exists as residual stress inside the deposition mask. A central region in a width direction of the deposition mask is an effective region in which a through hole is formed. In addition, a through hole is not formed in an outer region in the width direction (an end region in the width direction of the deposition mask). Accordingly, the stress difference of the deposition mask mainly occurs in the width direction of the deposition mask.

The deposition mask includes a groove formed in the ineffective region. Accordingly, it is possible to reduce a magnitude of the residual stress of the effective region. Accordingly, a difference of the residual stress between the effective region and the ineffective region is reduced.

Accordingly, the deposition mask can be prevented from being warped due to the difference in the residual stress.

In addition, a difference in strength of the first surface and the second surface of the deposition mask can be reduced. In detail, a groove is additionally formed in the ineffective region of the first surface where a small area hole is formed. Therefore, it is possible to reduce a difference in an opening ratio of the first surface and an opening ratio of the second surface. Therefore, it is possible to reduce the difference in strength between the first surface and the second surface.

Therefore, the deposition mask can be prevented from being warped due to the difference in strength.

### [Description of Drawings]

FIG. 1 is a drawing illustrating a combination of a deposition mask and a frame according to an embodiment.
FIG. 2 is a cross-sectional view of an organic deposition device including a deposition mask according to an embodiment.
FIG. 3 is a drawing illustrating that a deposition pattern is formed on a deposition substrate by a through hole of a deposition mask according to an embodiment.
FIG. 4 is a drawing illustrating that a deposition mask according to an embodiment is tensioned to be fixed on a mask frame.
FIG. 5 is a plan view of a deposition mask according to an embodiment.
FIG. 6 and FIG. 7 are enlarged views of region A of FIG. 5.
FIG. 8 is an enlarged view of region B of FIG. 7.

### [Best Mode]

Hereinafter, embodiments will be described in detail with reference to the accompanying drawings. However, the spirit and scope of the present invention is not limited to a part of the embodiments described, and may be implemented in various other forms, and within the spirit and scope of the present invention, one or more of the elements of the embodiments may be selectively combined and replaced. In addition, unless expressly otherwise defined and described, the terms used in the embodiments of the present invention (including technical and scientific terms) may be construed the same meaning as commonly understood by one of ordinary skill in the art to which this invention belongs, and the terms such as those defined in commonly used dictionaries may be interpreted as having a meaning that is consistent with their meaning in the context of the relevant art.

Further, the terms used in the embodiments of the present invention are for describing the embodiments and are not intended to limit the present invention. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present invention, the terms such as first, second, A, B, (a), and (b) may be used. These terms are only used to distinguish the elements from other elements, and the terms are not limited to the essence, order, or order of the elements.

In addition, when an element is described as being "connected", "coupled", or "connected" to another element, it may include not only when the element is directly "connected" to, "coupled" to, or "connected" to other elements, but also when the element is "connected", "coupled", or "connected" by another element between the element and other elements.

Further, when described as being formed or disposed "on (over)" or "under (below)" of each element, the "on (over)" or "under (below)" may include not only when two elements are directly connected to each other, but also when one or more other elements are formed or disposed between two elements.

Furthermore, when expressed as "on (over)" or "under (below)", it may include not only the upper direction but also the lower direction based on one element.

Hereinafter, a deposition mask according to an embodiment will be described with reference to the drawings.

The deposition mask described below is a fine metal mask (FMM) capable of depositing red, green, and blue organic materials on a deposition substrate to form an RGB pixel pattern on the deposition substrate. In addition, the following description does not apply to an open mask (OM).

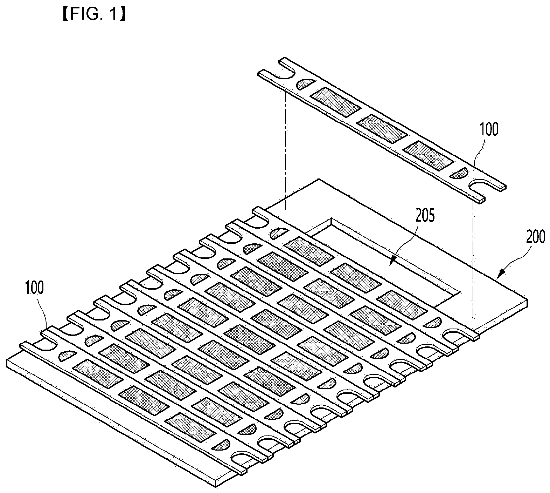

FIGS. 1 to 3 are drawings for explaining a process of depositing an organic material on a deposition substrate 300 using a deposition mask 100 according to an embodiment.

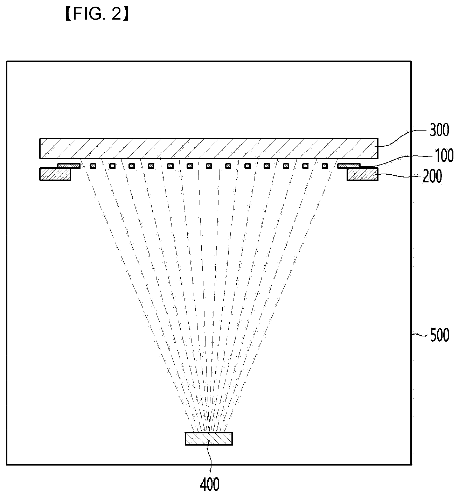

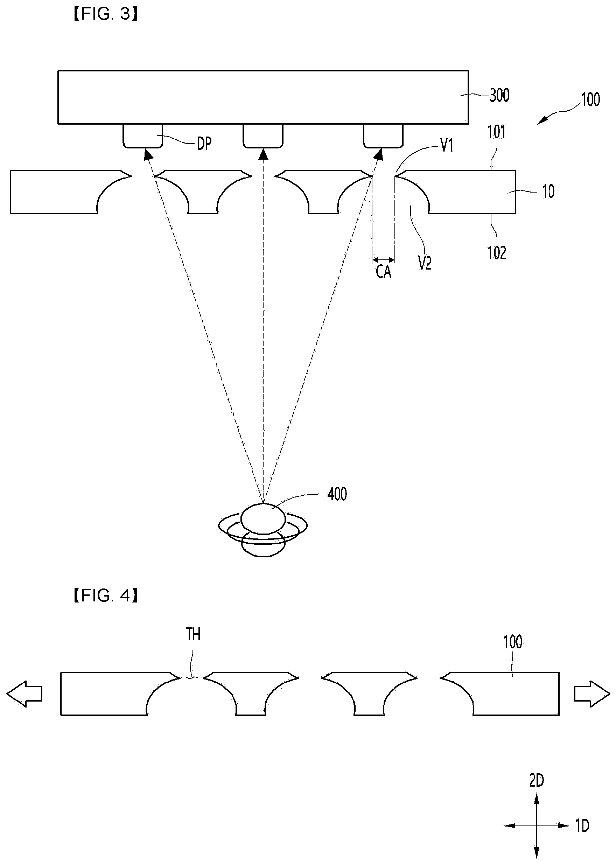

FIG. 1 is a drawing illustrating a combination of a deposition mask and a frame according to an embodiment, FIG. 2 is a cross-sectional view of an organic deposition device including a deposition mask according to an embodiment, and FIG. 3 is a drawing illustrating that a deposition pattern is formed on a deposition substrate by a through hole of a deposition mask according to an embodiment.

Referring to FIGS. 1 and 2, an organic material deposition device includes a deposition mask 100, a mask frame 200, a deposition substrate 300, an organic material deposition container 400, and a vacuum chamber 500.

The deposition mask 100 includes a metal. For example, the deposition mask includes iron (Fe) and nickel (Ni). In detail, the deposition mask includes an invar alloy including iron (Fe) and nickel (Ni).

The deposition mask 100 includes a plurality of through holes TH. The through holes are arranged in an effective portion. The through holes are arranged to correspond to a pixel pattern to be formed on a deposition substrate. The deposition mask 100 includes an ineffective portion other than an effective portion including a deposition region.

The mask frame 200 includes an opening 205. The plurality of through holes are arranged on a region corresponding to the opening 205. Accordingly, an organic material supplied to the organic material deposition container 400 is deposited on the deposition substrate 300. The deposition mask 100 is arranged and fixed on the mask frame 200. For example, the deposition mask 100 is tensioned with a constant tensile force. In addition, the deposition mask 100 is welded and fixed on the mask frame 200.

For example, the non-effective portion of the deposition mask 100 is welded. By this, the deposition mask 100 is fixed on the mask frame 200. Then, a portion protruding outwardly of the mask frame 200 is cut and removed.

The mask frame 200 includes a metal having high rigidity. By this, a deformation of the mask frame is reduced during a welding process.

The deposition substrate 300 is a substrate used when manufacturing a display device. For example, an OLED pixel pattern is formed on the deposition substrate 300. In order to form pixels, which are three primary colors of light, organic patterns of red, green, and blue are formed on the deposition substrate 300. That is, an RGB pattern is formed on the deposition substrate 300.

The organic deposition container 400 is a crucible. An organic material is disposed inside the crucible. The organic material deposition container 400 moves within the vacuum chamber 500. That is, the organic material deposition container 400 moves in one direction within the vacuum chamber 500. For example, the organic material deposition container 400 moves in a width direction of the deposition mask 100 within the vacuum chamber 500.

A heat source and/or current is supplied to the organic material deposition container 400. Accordingly, the organic material is deposited on the deposition substrate 300.

Referring to FIG. 3, the deposition mask 100 includes a metal plate 10. The metal plate includes a first surface 101 and a second surface 102. The first surface 101 and the second surface 102 are opposite surfaces.

The first surface 101 includes a small area hole V1. The second surface 102 includes a large area hole V2. For example, a plurality of small area holes V1 and a plurality of large area holes V2 are formed on the first surface 101 and the second surface 102, respectively.

In addition, the deposition mask 100 includes a through hole TH. The through hole TH is formed by a connecting portion CA connecting boundaries of the small area hole V1 and the large area hole V2.

A width of the large area hole V2 is larger than a width of the small area hole V1. The width of the small area hole V1 is measured on the first surface 101 of the deposition mask 100. The width of the large area hole V2 is measured on the second surface 102 of the deposition mask 100.

In addition, a width of the connecting portion CA has a set size. In detail, the width of the connection portion CA may be 15 µm to 33 µm. In more detail, the width of the connection portion CA may be 19 µm to 33 µm. In more detail, the width of the connection portion CA may be 20 µm to 27 µm. If the width of the connection portion CA exceeds 33 µm, it is difficult to implement a resolution of 500 PPI or higher. In addition, if the width of the connection portion CA is less than 15 µm, a defect may occur during a deposition process.

The small area hole V1 faces the deposition substrate 300. The small area hole V1 is arranged close to the deposition substrate 300. Accordingly, the small area hole V1 has a shape corresponding to a deposition pattern DP.

The large area hole V2 faces the organic material deposition container 400. Accordingly, the organic material supplied from the organic material deposition container 400 can be accommodated in a wide width by the large area hole V2. In addition, a fine pattern can be quickly formed on the deposition substrate 300 through the small area hole V1.

Accordingly, the organic material accommodated by the large area hole V1 is deposited on the deposition substrate 300 by the small area hole V1. Accordingly, one of the red, green, or blue pixel patterns is formed on the deposition substrate 300. Subsequently, the above process is repeated. Accordingly, all of the red, green, or blue pixel patterns are formed on the deposition substrate 300.

Meanwhile, referring to FIG. 4, the deposition mask 100 is tensioned in one direction. In detail, when the deposition mask 100 is fixed to the mask frame 200, the deposition mask 100 is tensioned in the first direction 1D. In detail, the deposition mask 100 is tensioned in a longitudinal direction.

Therefore, stress generated by tension remains inside the deposition mask 100. The deposition mask 100 includes a region where a through hole is formed and a region where a through hole is not formed. Therefore, a residual stress of a region where the through hole is formed and a residual stress of a region where the through hole is not formed may be different.

Therefore, a stress difference occurs in the region where the through hole is formed and the region where the through hole is not formed. Accordingly, the deposition mask may bend at a boundary region between the region where the through hole is formed and the region where the through hole is not formed.

Therefore, the deposition efficiency of the deposition mask may decrease.

Hereinafter, a deposition mask capable of resolving the above-mentioned stress difference will be described.

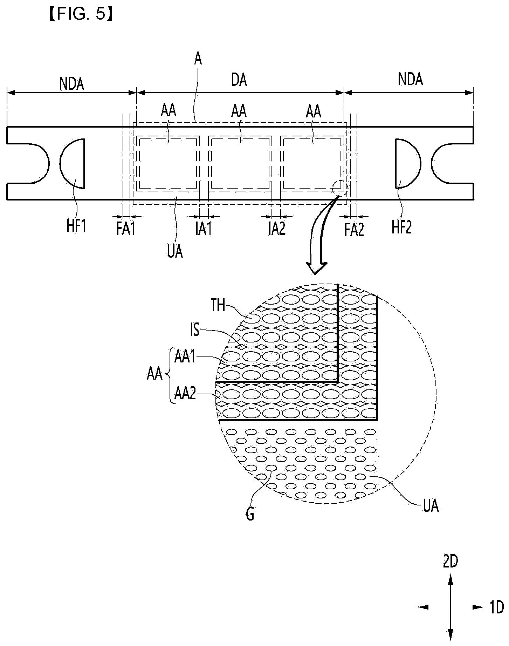

FIG. 5 is a plan view of a deposition mask 100 according to an embodiment.

Referring to FIG. 5, the deposition mask 100 includes a deposition region DA and a non-deposition region NDA.

The deposition region DA is a region for forming a deposition pattern. The deposition region DA can be defined as a region from a point where a through hole or hole first starts to a point where the through hole or hole ends in a longitudinal direction of the deposition mask 100.

The deposition region DA includes an effective region AA and an ineffective region UA. The effective region AA is a region where a through hole TH and an island portion IS are formed. The ineffective region UA is a region where the through hole TH and the island portion IS are not formed. The ineffective region UA is a region where a groove G is formed. The island portion IS is a region where the metal plate 10 is not etched.

In addition, the deposition region DA includes a plurality of effective regions.

The deposition region DA includes a plurality of separation regions IA1 and IA2. The separation regions IA1 and IA2 are arranged between adjacent effective regions. The separation regions IA1 and IA2 are separation regions between the plurality of effective regions. The adjacent effective regions can be distinguished from each other by the separation regions IA1 and IA2. In addition, one deposition mask 100 can support a plurality of effective regions.

The non-deposition region NDA is a region that does not participate in deposition. The non-deposition region NDA includes a frame fixing region FA1 and FA2. The frame fixing region FA1 and FA2 is a region for fixing the deposition mask 100 to the mask frame 200. In addition, the non-deposition region NDA can include a half-etching portion HF1 and HF2 and an open portion.

The half-etching portion HF1 and HF2 can disperse the stress generated when tensioning the deposition mask 100.

In addition, the open portion can disperse the stress generated when tensioning the deposition mask 100. Accordingly, deformation of the deposition mask can be reduced.

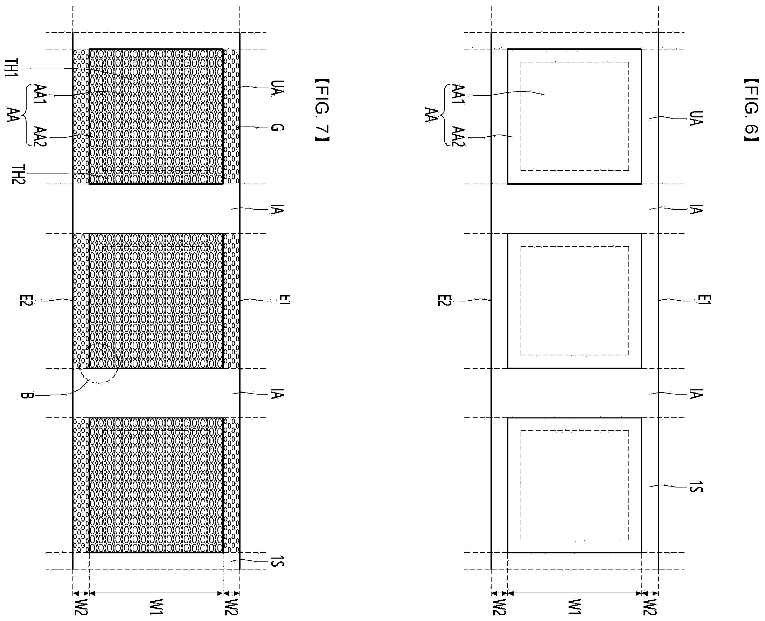

FIGS. 6 and 7 are enlarged views of region A of FIG. 5. In detail, FIGS. 6 and 7 are enlarged views of the deposition region DA. FIG. 6 is a drawing before a through hole and a groove are formed in the deposition region DA. FIG. 7 is a drawing after a through hole and a groove are formed in the deposition region DA.

Referring to FIG. 6, the deposition region DA includes an effective region AA, an ineffective region UA, and a separation region IA.

The effective region AA is a region in which a through hole TH is formed. In detail, a plurality of through holes TH are formed in the effective region AA.

The effective region AA includes a first effective region AA1 and a second effective region AA2. The second effective region AA surrounds the first effective region AA1. In addition, an area of the first effective region AA1 is larger than an area of the second effective region AA.

The separation region IA is a region that separates a plurality of effective regions AA. Adjacent effective regions AA are separated by the separation region IA. In detail, effective regions AA adjacent in the first direction 1D are separated by the separation region IA. In detail, effective regions AA adjacent in the longitudinal direction of the deposition mask 100 are separated by the separation region IA.

The ineffective region UA is a region in which the through hole TH is not formed. The ineffective region UA is arranged above and below the effective region AA. The deposition mask 100 includes a first end E1 and a second end E2 in the second direction 2D. The first end E1 and the second end E2 face each other in the width direction of the deposition mask 100.

The ineffective region UA is arranged at least one of between the effective region AA and the first end E1 and between the effective region AA and the second end E2.

Widths of the effective region AA and the ineffective region UA are different. In detail, a width W1 of the effective region AA in the second direction and a width W2 of the ineffective region UA in the second direction are different.

In detail, the width W1 of the effective region AA is larger than the width W2 of the ineffective region UA. For example, the width W1 of the effective region AA may be 90% or more and less than 100% of the width of the metal plate 100. In detail, the width W1 of the effective region AA may be 93% or more and less than 100% of the width of the metal plate 100. In detail, the width W1 of the effective region AA may be 95% or more and 98% of the width of the metal plate 100.

In addition, the width W2 of the ineffective region UA may be more than 0% and less than 10% of the width of the metal plate 100. In detail, the width W2 of the ineffective region UA may be more than 0% and less than 5% of the width of the metal plate 100. In detail, the width W2 of the ineffective region UA may be more than 0% and less than or equal to 3% of the width of the metal plate 100.

Since the widths of the effective region AA and the ineffective region UA are set to the above range, a spacing and a size of the through holes formed inside the effective region AA can be formed to a range set according to the deposition efficiency. In addition, a size of the deposition mask can be prevented from increasing due to the ineffective region UA. In addition, the stress difference caused by the ineffective region UA can be improved.

Referring to FIG. 7, a plurality of through holes are formed in the effective region AA. In detail, a first through hole TH1 is formed in a first effective region AA1. A deposition pattern can be deposited on the deposition substrate 300 by the first through hole TH1.

A second through hole TH2 is formed in a second effective region AA2. The second through hole TH2 is formed in a shape identical to or similar to that of the first through hole TH1. In addition, the second through hole TH2 is formed in a size identical to or similar to that of the first through hole TH1.

The organic material can flow into the second through hole TH2. However, the organic material flowing into the second through hole TH2 is not deposited on the deposition substrate 300.

The second through hole TH2 can prevent etching failure of the first through hole TH1. In detail, the size and/or spacing of the first through holes TH arranged in the first effective region AA1 become uniform due to the second through hole TH2.

A surface of the metal plate is exposed in the separation region IA. No through hole or groove is formed in the separation region IA. That is, the separation region IA is a region where the first surface 1S is exposed. That is, an opening ratio of the separation region IA is 0%.

Therefore, the deposition mask 100 can maintain a strength of the deposition mask by the separation region IA.

A groove G is formed in the ineffective region UA. In detail, a plurality of grooves G are formed in the ineffective region UA. The groove G is formed by etching one surface of the metal plate 10. In detail, the groove G is formed by partially etching the first surface 1S. Accordingly, the groove G penetrates the first surface 1S and does not penetrate the second surface 2S.

The groove G may be formed in a same shape as at least one of the first through hole TH1 and the second through hole TH. Alternatively, the groove G may be formed in a different shape from at least one of the first through hole TH1 and the second through hole TH2.

A size of the groove G may be different from a size of at least one of the first through hole TH1 and the second through hole TH. For example, the size of the groove G may be smaller than a size of at least one of the first through hole TH1 and the second through hole TH.

A pitch of the grooves G may be different from a pitch of at least one of the through holes of the first through hole TH1 and the second through hole TH. For example, the pitch of the groove G may be smaller than the pitch of at least one of the through holes of the first through hole TH1 and the second through hole TH.

Accordingly, even if the groove is formed without forming the through hole in the ineffective region, the stress distribution can be efficiently controlled.

An opening ratio of the effective region AA and an opening ratio of the ineffective region UA are different. In detail, the opening ratio of the effective region AA is larger than the opening ratio of the ineffective region UA. Here, the opening ratio of the effective region AA is defined as an opening ratio of the small area hole V1 formed on the first surface 1S. In addition, the opening ratio of the ineffective region UA is defined as an opening ratio of the groove G formed on the first surface 1S.

The opening ratio of the effective region AA may be 5 times or more the opening ratio of the ineffective region UA. In detail, the opening ratio of the effective region AA may be 7 times or more the opening ratio of the ineffective region UA. In detail, the opening ratio of the effective region AA may be 10 times or more the opening ratio of the ineffective region UA. In detail, the opening ratio of the effective region AA may be 5 to 15 times the opening ratio of the ineffective region UA.

Alternatively, the opening ratio of the effective region AA may be 20% or more of an area of the deposition region DA of the metal plate. In detail, the opening ratio of the effective region AA may be 25% or more of the area of the deposition region DA of the metal plate. In detail, the opening ratio of the effective region AA may be 20% to 40% of the area of the deposition region DA of the metal plate.

Alternatively, the opening ratio of the ineffective region UA may be 10% or less of the area of the deposition region DA of the metal plate. In detail, the opening ratio of the ineffective region UA may be 5% or less of the area of the deposition region DA of the metal plate. In detail, the opening ratio of the ineffective region UA may be 2% to 4% of the area of the deposition region DA of the metal plate.

Since the opening ratio of the effective region AA and the ineffective region UA is set to the above range, the organic material can be stably deposited on the deposition substrate 300 by the effective region AA.

In addition, the warping of the ineffective region UA can be prevented.

The deposition mask includes a hole or groove formed in the effective region AA and the ineffective region UA. Therefore, the stress difference that occurs when the deposition mask 100 is tensioned can be reduced. That is, when the deposition mask 100 is tensioned, stress due to tension is generated. The stress exists as residual stress in the deposition mask.

The deposition mask 100 includes a groove formed in the ineffective region UA. Therefore, a magnitude of the residual stress of the ineffective region can be reduced. Therefore, the difference in the residual stress between the effective region AA and the ineffective region UA is reduced.

Accordingly, the deposition mask can be prevented from being warped due to the difference in the residual stress.

In addition, the difference in strength between the first surface and the second surface of the deposition mask can be reduced. Specifically, a groove is additionally formed on the ineffective region of the first surface where a small area hole is formed. Therefore, a difference in the opening ratio of the first surface and the opening ratio of the second surface is reduced.

Therefore, the difference in strength between the first surface and the second surface is reduced. Therefore, the deposition mask can be prevented from being warped due to the difference in strength.

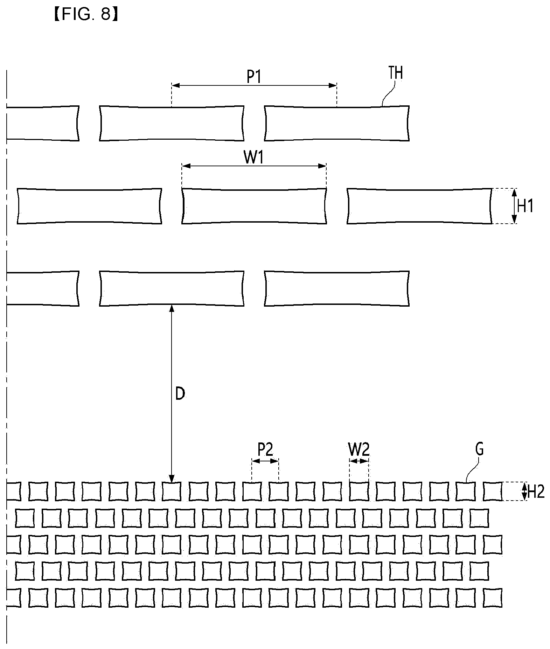

FIG. 8 is a drawing for explaining a size and a spacing of the through holes TH1 and TH2 and the grooves G of the deposition mask according to an embodiment.

Referring to FIG. 8, a pitch P1 of the through holes TH1 and TH2 can be 50 µm to 200 µm. In addition, a width W1 of the through holes TH1 and TH2 can be 10 µm to 200 µm. In addition, a height H1 of the through holes TH1 and TH2 can be 10 µm to 200 µm.

In addition, a pitch P2 of the groove G may be less than 50% of the pitch P1 of the through hole TH1 and TH2. In addition, a width W2 of the groove G may be less than 50% of the width W1 of the through hole TH1 and TH2. In addition, a height H2 of the groove G may be less than 50% of the height H1 of the through hole TH1 and TH2.

In addition, a spacing D between the through hole TH1 and TH2 and the groove G may be 50% or more of the pitch P1 of the through hole TH1 and TH2. The spacing between the through hole TH1 and TH2 and the groove G may be a spacing in the longitudinal direction of the deposition mask 100.

The size and spacing of the through hole TH1 and TH2 and the groove G are formed within a set range. Accordingly, the deposition mark can improve the deposition efficiency by the through hole. In addition, the bending of the deposition mark can be prevented by the groove.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The above description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. A deposition mask comprising:
a metal plate including a deposition region and a non-deposition region,
wherein the deposition region includes at least one effective region and at least one ineffective region,
wherein the effective region includes a plurality of through holes,
wherein the through holes include a small area hole formed on a first surface of the metal plate; a large area hole formed on a second surface of the metal plate; and a communication portion communicating the small area hole and the large area hole, and
wherein the ineffective region includes a plurality of grooves.

2. The deposition mask of claim 1, wherein the metal plate includes a first end and a second end facing each other in a width direction of the metal plate, and
wherein the ineffective region is disposed at least one of between the effective region, and between the first end and the effective region and the second end.

3. The deposition mask of claim 2, wherein the effective region includes a first effective region and a second effective region arranged to surround the first effective region,
wherein a first through hole is arranged in the first effective region, and
wherein a second through hole is arranged in the second effective region.

4. The deposition mask of claim 3, wherein a size of the groove is smaller than a size of at least one of the first through hole and the second through hole.

5. The deposition mask of claim 3, wherein a pitch of the groove is smaller than a pitch of at least one of the first through hole and the second through hole.

6. The deposition mask of claim 1, wherein a width of the metal plate of the ineffective region in the width direction is greater than 0% and less than or equal to 10% of a width of the metal plate.

7. The deposition mask of claim 1, wherein an opening ratio of the effective region is 5 to 15 times an opening ratio of the ineffective region.

8. The deposition mask of claim 1, wherein the opening ratio of the ineffective region is 2 to 4% of an area of the deposition region of the metal plate.

9. The deposition mask of claim 1, wherein the groove is formed on the first surface.

10. The deposition mask of claim 1, wherein the effective region includes a plurality of effective regions spaced apart in a longitudinal direction of the metal plate,
wherein a separation region is arranged between effective regions adjacent in the longitudinal direction of the metal plate, and
wherein the separation region exposes the first surface of the metal plate.
